# EUROPEAN PATENT SPECIFICATION

(11) **EP 0 565 003 B1**
(45) Date of publication and mention of the grant of the patent: **15.07.1998**
(21) Application number: 93105525.5
(22) Date of filing: 02.04.1993
(51) Int. Cl.: G11C 27/04, G11C 11/56

(54) **Memory device**
Speicheranordnung
Dispositif de mémoire

(30) Priority: 07.04.1992 JP 113956/92
(43) Date of publication of application: 13.10.1993
(73) Proprietor: YOZAN INC., Tokyo 155 (JP); SHARP KABUSHIKI KAISHA, Osaka-shi, Osaka-fu 545 (JP)
(72) Inventor: Yamamoto, Makoto, c/o Yozan Inc., Tokyo 155 (JP)
(74) Representative: Grünecker, Kinkeldey, Stockmair & Schwanhäusser Anwaltssozietät

(56) References cited:
- US-A- 4 209 852
- ELECTRONIC DESIGN. vol. 34, no. 6 , March 1986 , HASBROUCK HEIGHTS, NEW JERSEY pages 117 - 121 CAKE ET AL 'WAVEFORM DIGITIZER SNARES SINGLE -SHOT EVENTS AT 1.348 GSAMPLES/S'
- IBM TECHNICAL DISCLOSURE BULLETIN. vol. 20, no. 1 , June 1977 , NEW YORK US pages 379 - 382 TAUB 'RESTANDARIZING CIRCUIT FOR ANALOGUE CCD SHIFT REGISTER'

## Description

The present invention relates to a memory device, according to the preamble portion of claim 1.

The reason why a digital computer has made progress as a programmable computer can be conceived that the size and the capacity of a digital memory has rapidly advanced into small and large, respectively, than an analog memory. But recently, it is close to the limit to produce higher density of digital LSI: the development of a digital computer has the limit without doubt. Conventionally, the scale of a circuit is large and the process of the production is complicated in order to realize a memory in analog or in multilevel.

It is the object of the present invention to provide a memory device, according to the preamble portion, which has a reduced access time.

This object is solved by the subject matter of claim 1.

A memory device related to this invention holds a plural number of analog data by circulating data on linear CCD array. A refresh circuit is set for inputting data on the beginning point and also set a shaping circuit for preventing poorness of data in this memory device.

It is possible to realize an analog memory or a multilevel memory, easy to produce and with small scale of a circuit by the memory device relates to this invention.

A preferred embodiment of the present invention is discussed in more detail here and below in connection with the accompanied drawings.

Figure 1 shows a block diagram of an embodiment of the memory device according to this invention.

Figure 2 shows a graph of characteristics of the shaping circuit in the embodiment.

Figure 3 shows the outline of the structure of CCD array.

Figure 4 shows a timing chart of clocks to be input to the CCD array.

Figure 5 shows a block diagram of a neural device using the memory device of this invention.

Hereinafter, an embodiment of the memory device according to this invention is described with reference to the attached drawings.

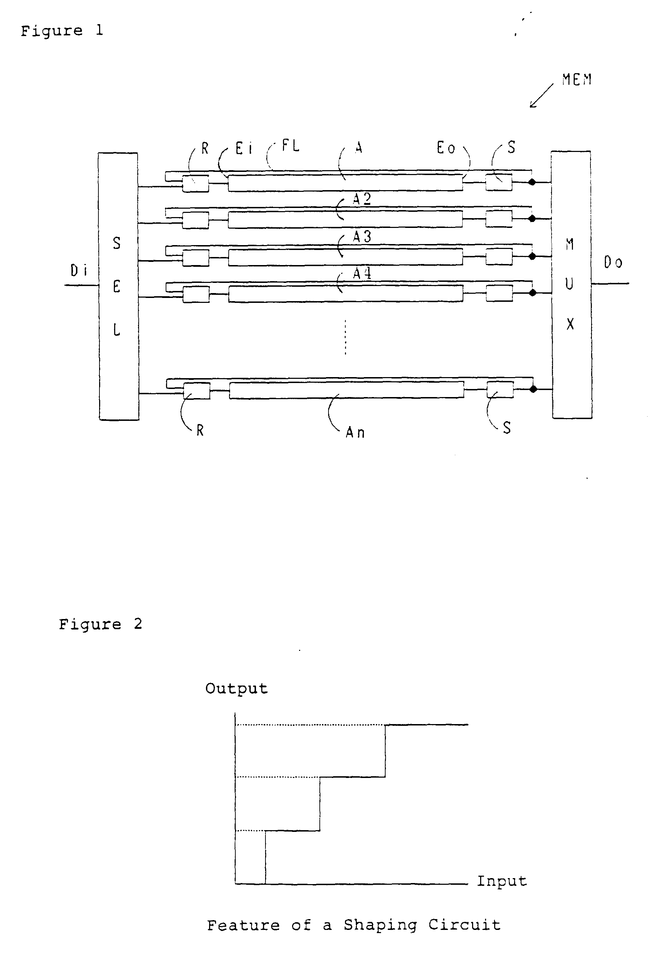

Figure 1 shows the outline of the memory device. The memory device MEM comprises a plural number of CCD arrays from "A1" to "An" each of which is connected a refresh circuit "R" on the end of input "Ei" and a shaping circuit "S" on the end of output "Eo". Refresh circuit "R" gives CCD on the end of input Ei the electrical charge corresponding to input data Di. Shaping circuit S adjusts data output from output end Eo. This is the level adjustment of data to be feedback to the end of input. It is "level shift circuit" in analog memory, and "multilevel A/D converter" in multilevel memory as shown in Figure 2. The data feedback from the end of output Eo to the input end Ei is performed through feedback line FL.

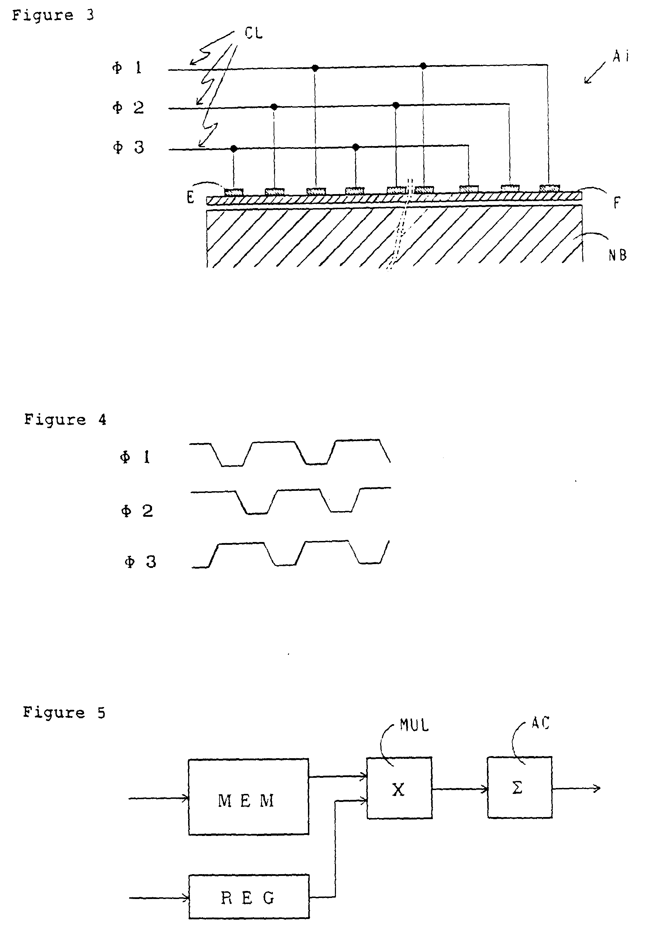

A CCD array Ai is constructed as in Figure 3. Film "F" is formed from SiO₂ on n-type board NB. Electrode "E" is arranged in plural on the film F. Each electrode E corresponds one held datum: different topology from Φ1 to Φ3 (shown in Figure 4) are input from topology differential clock line CL to adjacent three electrodes. These clocks transmit a small number of carriers stored in a potential well to outer side by minus voltage of adjacent electrodes.

The structure of CCD is much simple than the cell of an ordinal DRAM and the necessary area for storing one analog datum is small.

Input data is given to each CCD array Ai through the selector SEL, and output data Do of each CCD array is selectively output through multiplexer MUX. When a memory device is accessed in random, data is transmitted on the CCD array after a CCD array is selected. The necessary data is transmitted to the CCD on input end Ei when data is written, and is transmitted to the CCD on output end Eo when data is read. The maximum time for this transmission can be calculated by multiplying one cycle of transmission time to the number of CCD in one CCD array. Therefore, it is possible to decrease the number of CCD of each CCD array, to decrease the number of transmission cycle for random access, and consequently to shorten the access time by setting a plural number of CCD array.

Figure 5 shows a block diagram of the neural device using the above-mentioned memory device MEM. The output of memory device and the data of register REG is input to multiplication means MUL. The multiplication of them is calculated. The output of multiplication means MUL is input to accumulator AL and the accumulation is performed. Usually, the accumulation below is necessary for the computation of neural network.$\text{Σ(Wi×Ai)}$
- Wi:: weight
- Ai:: input
It is calculated by the circuit in Figure 5. Random access is not necessary because the order of the data for this computation is fixed, and weight data corresponding to input data stored in the memory device is read in order. That is, the merit of the memory device described above can be used effectively.

As mentioned, a memory device according to this invention holds a plural number of analog data by circulating data on linear CCD array. A refresh circuit is set for inputting data on the beginning point and also set a shaping circuit for preventing poorness of data in this memory device. Therefore, it is possible to realize an analog memory or multilevel memory, which is easy to produce and whose circuit is small.

## Claims

1. A memory device comprising:
a CCD array (Aᵢ) composed of a plurality of CCDs arranged in linear;
a refresh circuit (R) connected to a CCD on one end of said CCD array (Aᵢ),
a shaping circuit (S) connected to a CCD on another end of said CCD array (Aᵢ);
a feedback line (FL) for connecting an output of said shaping circuit (S) to an input of said refresh circuit (R); and
a phase difference clock line for transmitting data of said CCD array (Aᵢ)
**characterised by**
further comprising
a plurality of said CCD arrays each having an associated refresh circuit (R), shaping circuit (S) and feedback line (FL), and a selector (SEL) for inputting an input data to said input of said refresh circuit (R) of one of said CCD arrays (Aᵢ) and a multiplexer (MUX) for outputting an output data from said output of said shaping circuit (S) of one of said CCD arrays (Aᵢ).

## Patentansprüche

1. Speichereinrichtung mit:
einem CCD- Feld (Ai) bestehend aus einer Vielzahl von hintereinander angeordneten CCDs;
einem Wiederauffrischungsschaltkreis (R), der mit einem CCD an einem Ende des CCD- Feldes (Ai) verbunden ist;
einem Formungsschaltkreis (S) der mit einem CCD am anderen Ende des CCD-Feldes (Al) verbunden;
einer Rückführungsleitung (FL) zum Verbinden eines Ausgangs des Formungsschaltkreises(S) mit einem Eingang des Wiederauffrischungsschalters (R);
einer Phasendifferenztaktleitung zum Übertragen von Daten des CCD- Feldes (Ai),
**dadurch gekennzeichnet, daß** weiterhin eine Vielzahl von CCD- Feldern vorgesehen ist, von denen jedes einen Wiederauffrischungsschaltkreis (R), einen Formungsschaltkreis (S) und eine Rückführungsleitung (FL) aufweist und weiterhin ein Selektor (SEL) zum Eingeben von Eingangsdaten an den Eingang des Wiederauffrischungsschaltkreises von einem CCD- Feld (Ai) sowie ein Multiplexer (MUX) vorgesehen ist, zum Ausgeben von Ausgangsdaten von dem Ausgang des Formungsschaltkreises (S) von einem der CCD- Felder (Ai).

## Revendications

1. Dispositif de mémoire comprenant :
un réseau CCD (Ai) composé d'une pluralité de dispositifs CCD disposés linéairement ;
un circuit de rafraîchissement (R) connecté à un dispositif CCD à une extrémité dudit réseau CCD (Ai) ;
un circuit de mise en forme (S) connecté à un dispositif CCD à une autre extrémité dudit réseau CCD (Ai) ;
une ligne de retour (FL) pour connecter une sortie dudit circuit de mise en forme (S) à une entrée dudit circuit de rafraîchissement (R) ; et,
une ligne d'horloge de déphasage pour transmettre des données dudit réseau CCD (Ai),
caractérisé en ce qu'il comprend en outre une pluralité desdits réseaux CCD comportant chacun un circuit de rafraîchissement (R), un circuit de mise en forme (S) et une ligne de retour (FL) associés, et un sélecteur (SEL) pour entrer des données d'entrée à ladite entrée dudit circuit de rafraîchissement (R) de l'un desdits réseaux CCD (Ai) et un multiplexeur (MUX) pour sortir des données de sortie par ladite sortie dudit circuit de mise en forme (S) de l'un desdits réseaux CCD (Ai).
